# EUROPÄISCHE PATENTSCHRIFT

(11) **EP 3 042 553 B1**
(45) Veröffentlichungstag und Bekanntmachung des Hinweises auf die Patenterteilung: **31.08.2022**
(21) Anmeldenummer: 14777490.5
(22) Anmeldetag: 03.09.2014
(51) Int. Cl.: H05K 3/30, H05K 3/34

(54) **VERFAHREN ZUM POSITIONSSTABILEN VERLÖTEN**
METHOD FOR POSITIONALLY STABLE SOLDERING
PROCÉDÉ PERMETTANT UN BRASAGE STABLE

(30) Priorität: 03.09.2013 AT 505412013
(43) Veröffentlichungstag der Anmeldung: 13.07.2016
(73) Patentinhaber: ZKW Group GmbH, 3250 Wieselburg (AT)
(72) Erfinder: KIESLINGER, Dietmar, A-2604 Theresienfeld (AT); WURM, Peter, A-7000 Eisenstadt (AT)
(74) Vertreter: Patentanwaltskanzlei Matschnig & Forsthuber OG
(86) Internationale Anmeldenummer: PCT/AT2014/050194
(87) Internationale Veröffentlichungsnummer: WO 2015/031928

(56) Entgegenhaltungen:
- US-A1- 2007 035 021
- US-A1- 2008 303 145
- US-A1- 2010 302 749
- US-A1- 2011 051 032
- US-B1- 6 225 573

## Beschreibung

Die Erfindung betrifft ein Verfahren zum positionsstabilen Verlöten zumindest einer Bauteilkontaktfläche eines elektronischen Bauteils mit zumindest einer korrespondierenden Trägerplattenkontaktfläche einer Trägerplatte, wobei das zumindest eine elektronische Bauteil eine untere und obere Fläche sowie zumindest eine die untere mit der oberen Fläche verbindende Seitenfläche aufweist, wobei die Bauteilkontaktfläche an der unteren Fläche ausgebildet ist und die Trägerplattenkontaktfläche zumindest teilweise Lötmaterial aufweist und wobei das elektronische Bauteil in optoelektronisches Bauteil ist, das an seiner oberen Fläche eine Kopplungsfläche aufweist.

Das Anbringen von elektronischen Bauteilen an Trägerplatten, beispielsweise an Printplatten, ist ein sehr häufig erforderlicher Vorgang bei der Herstellung von elektrischen Schaltkreisen. Printplatten weisen dabei im Allgemeinen Leiterbahnen auf, die einzelne oder mehrere Anschlusskontakte miteinander verbinden, wobei einzelne elektronische Bauteile mit den elektrischen Anschlusskontakten verbunden werden. Die Verbindung kann mehrere Aspekte wie beispielsweise eine elektrische, mechanische und/oder thermische Verbindung aufweisen.

Aus dem Stand der Technik sind unterschiedliche Methoden bekannt geworden, mithilfe derer eine Verbindung eines elektronischen Bauteils mit einer Trägerplatte realisiert werden kann. So können beispielsweise Kontaktflächen einzelner elektronischer Bauteile mit an den Trägerplatten angeordneten Kontaktflächen verlötet werden.

An dieser Stelle sei auf das SMT-Verfahren (Surface Mount Technology) verwiesen, bei welchem sich die elektrischen Anschlüsse bzw. Kontaktflächen des elektronischen Bauteils sowie die korrespondierenden Kontaktflächen der Trägerplatte jeweils an deren Oberfläche befinden und die elektronischen Bauteile lediglich an der Oberfläche der Trägerplatte befestigt werden müssen und auf das Vorsehen von Durchgangsbohrungen verzichtet werden kann. Die Kontaktflächen der Trägerplatte werden hierbei zuerst mit einem Lötmittel, zumeist einer Lötpaste, beschichtet. Im Anschluss erfolgt die Bestückung der Trägerplatte mit einzelnen elektronischen Bauteilen.

Zur Herstellung einer dauerhaften elektrischen und/oder thermischen und/oder mechanischen Verbindung der elektronischen Bauteile mit der Trägerplatte ist beispielsweise das Reflow-Lötverfahren bekannt geworden, bei welchem die Lötpaste und die Kontaktflächen nach der Bestückung mit den elektronischen Bauteilen dergestalt erhitzt werden, dass die Lötpaste schmilzt und sich mit den Kontaktflächen der Trägerplatte sowie des jeweiligen elektronischen Bauteils verbindet.

Typische elektronische Bauteile wiegen nur wenige Milligramm. Aufgrund der hohen Dichte des geschmolzenen Lots (der Lötpaste) schwimmen die elektronischen Bauteile auf dem geschmolzenen Lot auf. Durch die Oberflächenspannung des flüssigen Lots und eventuell vorhandener Flussmittelreste können minimale Kräfte wirken, welche ein Verschieben, Verdrehen bzw. Verschwimmen einzelner elektronischer Bauteile in eine häufig stabile, zumeist aber schwer vorhersagbare Position bewirken können.

Dieses Verschieben, Verdrehen bzw. Verschwimmen ("Einschwimmen") stellt für die elektrische Verbindung im Allgemein kein Problem dar. Vielmehr wird dieser Effekt sogar genutzt, um leicht fehlplatzierte elektronische Bauteile zurecht zu rücken.

Für Anwendungen, bei denen das genaue Einhalten einer Sollposition dieser elektronischen Bauteile in Bezug auf die Trägerplatte von Bedeutung ist, kann dieser Einschwimmvorgang unzulässige Abweichungen von der jeweiligen Sollposition verursachen.

Eine Methode, mithilfe derer die Position einzelner elektronischer Bauteile bereits vor dem Lötvorgang festgelegt werden kann, besteht darin, die Bauteile mechanisch beispielsweise mittels Schraub- und/oder Klemmverbindungen fest zu spannen. Das Vorsehen solcher Schraub- und/oder Klemmverbindungen setzt allerdings das Vorhandensein mechanischer Angriffspunkte an den Trägerplatten und den elektronischen Bauteilen voraus, wodurch der Miniaturisierung der elektronischen Bauteile und/oder die Dichte der Bestückung der Trägerplatte Grenzen gesetzt sind. Auch konventionelle Vorklebeverfahren, bei welchen die Klebemittel auf die Unterseite der elektronischen Bauteile angebracht wird und mit die elektronischen Bauteile somit mit einer Trägerplatte verklebt werden können, setzen das Vorhandensein freier Klebeflächen an der Unterseite des elektronischen Bauteils voraus. Dies ist häufig nicht der Fall, insbesondere dann, wenn die Unterseite der elektronischen Bauteile im Wesentlichen vollständig aus Kontaktflächen gebildet wird.

US 2010/302749 A1 betrifft ein Verfahren zum Verlöten von BGA-Modulen auf Leiterplatten und offenbart die folgenden Schritte: a) Anbringen von Klebepunkten an der Trägerplatte, wobei die Position jedes Klebepunktes vorgegeben wird, b) Bestücken der Trägerplatte mit dem elektronischen Bauteil, wobei die Position der Klebepunkte in Schritt a) dergestalt vorgegeben wird, dass das elektronische Bauteil die Klebepunkte in einem durch die Seitenfläche und die untere Fläche gebildeten Kantenbereich kontaktiert, c) Abwarten eines Aushärtevorgangs der Klebepunkte für eine vorgebbare Zeitdauer, d) Erhitzen der BGA Lotkugeln zum Herstellen einer elektrischen, mechanischen und thermischen Verbindung.

Weiterer relevanter Stand der Technik ist in US 2011/051032 A1, US 2008/303145 A1 und US 6 225 573 B1 offenbart.

Es ist daher eine Aufgabe der Erfindung ein Verfahren zum positionsstabilen Verlöten der eingangs genannten Art schaffen, welches einfach ausführbar ist, eine platzsparende Anordnung der elektronischen Bauteile erlaubt und trotzdem eine dauerhaft stabile elektrische, mechanische und/oder thermische Verbindung der elektronischen Bauteile mit einer Trägerplatte ermöglicht. Unter einem optoelektronischen Bauteil werden elektronische Bauteile verstanden, die elektrische Signale in Licht wandeln und/oder Licht in elektrische Signale wandeln können, wobei unter dem Begriff Licht elektromagnetische Wellen mit einer Wellenlänge von vorzugsweise 100 nm bis 1cm, vorzugsweise 400nm bis 700nm verstanden wird. Beispielhaft seien hierfür elektrische Bauteile wie LED's, Laserdioden, Diodenlaser, Superstrahler, Photodioden bzw. beliebige andere optische elektronische Bauelemente erwähnt.

Diese Aufgabe wird mit einem Verfahren nach Anspruch 1 gelöst, welches erfindungsgemäß folgende Schritte aufweist:
a) Anbringen von zumindest zwei Klebepunkten an der Trägerplatte, wobei die Position jedes Klebepunktes vorgegeben wird, wobei die Trägerplatte bereits vor Schritt b) das Lötmaterial aufweist,
b) Bestücken der Trägerplatte mit dem zumindest einen elektronischen Bauteil, wobei die Position der Klebepunkte in Schritt a) dergestalt vorgegeben wird, dass das zumindest eine elektronische Bauteil die zumindest zwei Klebepunkte im Wesentlichen in einem durch die zumindest eine Seitenfläche und die untere Fläche gebildeten Kantenbereich kontaktiert und die zumindest eine Bauteilkontaktfläche mit der zumindest einen Trägerplattenkontaktfläche zumindest teilweise überlappt,
c) Abwarten eines Aushärtevorgangs der Klebepunkte für eine vorgebbare Zeitdauer t,
d) Erhitzen des Lötmaterials zum Herstellen einer elektrischen, mechanischen und/oder thermischen Verbindung zwischen der zumindest einen Bauteilkontaktfläche und der zumindest einen Trägerplattenkontaktfläche.

Dank des erfindungsgemäßen Verfahrens ist es möglich ein einzelnes oder mehrere elektronische Bauteile positionsstabil an einer Trägerplatte, typischerweise einer Printplatte, anzubringen und ein Verrutschen bzw. Verschwimmen einzelner elektronischer Bauteile beim Lötvorgang zu verhindern und gleichzeitig eine dichte Anordnung der elektronischen Bauteile zu ermöglichen. Darüber hinaus ist das erfindungsgemäße Verfahren einfach und kostengünstig ausführbar und ermöglicht eine dauerhaft stabile elektrische, mechanische und/oder thermische Verbindung der elektronischen Bauteile mit der Trägerplatte. Diese Verfahren kann für bekannte Lötverfahren, wie beispielsweise dem Reflow- Löt- oder dem Wellen- Lötverfahren, angewendet werden. Unter dem Begriff elektronische Bauteile werden optoelektronische

Bauteile, die eine exakte Position auf einer Trägerplatte einnehmen müssen (z.B. LEDs in optischen Modulen), erwähnt. Solche Bauteile und Trägerplatten werden beispielsweise in Fahrzeugen (als "Fahrzeugelektronik"), insbesondere in Fahrzeugscheinwerfern ("Scheinwerferelektronik) eingesetzt. Vorallem bei Scheinwerfermodulen ist die exakte Positionierung und Kontaktierung der Lichtquellen (welche vermehrt als Leuchtdioden oder Halbleiterlaserdioden in SMD-Bauform gebildet werden) immer wichtiger geworden. Die Bauteilkontaktfläche kann in Form und Größe mit jener der Trägerplattenkontaktfläche übereinstimmen. Auch kann die Bauteilkontaktfläche mit der Trägerplattenkontaktfläche bis zu 20, 30, 40, 50, 60, 70, 80, 90% oder vollständig überlappen (diese also überdecken).

Die Trägerplattenkontaktfläche ist erfindungsgemäß mit einem Lötmaterial, nämlich Lötpaste, beschichtet, welches vor (sowie vorzugsweise auch während) dessen Schmelzung plastisch verformbar ist, sodass die Position eines mit der Trägerplattenkontaktfläche in elektrischen Kontakt stehenden Bauteils verändert werden kann, ohne dass der elektrische Kontakt unterbrochen wird. Dadurch besteht die Möglichkeit, die Höhe des Bauteils in Bezug auf die Trägerplattenkontaktfläche zu verändern ohne den elektrischen Kontakt zu unterbrechen. Als besonders vorteilhaft hat sich herausgestellt, wenn das Lötmaterial mittels Siebdruck-Verfahren auf dem Träger aufgebracht wird, da dadurch die Koplanarität unter einzelnen Lötdepots sichergestellt ist und das Bauteil parallel zur Trägerplatte platziert werden kann.

Das Verschwimmen der elektronischen Bauteile an einer Lötstelle ist von dem Bauteilgewicht und der Ausdehnung (Fläche) der Trägerplattenkontaktfläche abhängig (genauer gesagt von ihrem Verhältnis). Typische elektronische Bauteile, die mittels dem erfindungsgemäßen Verfahren verlötet werden sollen, weisen ein Gewicht von zumindest 10mg bis zu einigen Gramm (z.B. thin quad flat pack's), beispielsweise 10g, auf. Das Verhältnis von Bauteilgewicht zu elektrisch wirksame Kontaktfläche beträgt vorteilhafterweise zwischen 1mg/mm² und 10mg/mm², jedenfalls bevorzugt weniger als 50mg/mm² und besonders bevorzugt weniger als 10mg/mm². Die elektrisch wirksame Kontaktfläche ist dabei jene Fläche, mit der das elektronische Bauteil die Trägerplatte elektrisch kontaktiert. Dabei ist es nicht von Bedeutung, ob die elektrisch wirksame Kontaktfläche an der Trägerplatte zu anderen Bauteilen oder Kontakten elektrisch fortgeführt wird oder nicht. Die elektrisch wirksame Kontaktfläche kann daher zur elektrischen Verbindung des elektronischen Bauteils mit anderen an der Trägerplatte befindlichen oder mit dieser verbundenen elektronischen Bauteile dienen und/oder zur mechanischen Stabilisierung des elektronischen Bauteils an der Trägerplatte und/oder zur Ableitung von Wärme von dem elektronischen Bauteil in die Trägerplatte eingesetzt werden. Die Trägerplattenkontaktfläche weist das Lötmaterial vorzugsweise bereits vor der Durchführung des Schritts b) besonders bevorzugt vor dem Schritt a) auf.

In einer vorteilhaften Ausführungsform des erfindungsgemäßen Verfahrens sind die Klebepunkte dergestalt angeordnet, dass eine gedachte Verbindungsgerade zwischen den Klebepunkten eine Gerade durch den Mittelpunkt der unteren Fläche des zumindest einen elektronischen Bauteils bildet. Dies erlaubt eine besonders einfache und zugleich stabile Fixierung des zumindest einen elektronischen Bauteils.

Darüber hinaus kann es in einer günstigen Weiterbildung des erfindungsgemäßen Verfahrens vorgesehen sein, dass die Klebepunkte dergestalt angeordnet sind, dass jeweils ein Klebepunkt an einer Ecke des zumindest einen elektronischen Bauteils angeordnet ist. Es können beispielsweise zwei Klebepunkte an gegenüber liegenden Ecken des elektronischen Bauteils angeordnet sein. Unter dem Ausdruck "Ecke des elektronischen Bauteils" wird ein Bereich verstanden, an welchem sich der Verlauf einer zwischen der Seitenfläche und der unteren Fläche gebildeten Kante des elektronischen Bauteils dergestalt ändert, dass eine Ecke ausgebildet wird. Alternativ dazu können die elektronischen Bauteile ebenso eine abgerundete, insbesondere einen kreisförmige untere Fläche aufweisen. Beispielsweise sind LED-SMDs (surface mounted devices) mit einer kreisförmigen unteren Fläche bekannt, wobei die die Klebepunkte an der Kante angebracht werden, die zwischen der unteren Fläche und der Seitenfläche dieser elektronischen Bauteile gebildet wird.

Eine besonders stabile Verbindung des elektronischen Bauteils mit der Trägerplatte kann realisiert werden, indem zu jeder Ecke des elektronischen Bauteils ein korrespondierender Klebepunkt vorgesehen ist. Das elektronische Bauteil weist vorzugsweise eine viereckige Bauform auf, wodurch in diesem Fall insgesamt vier Klebepunkte an Ecken des elektronischen Bauteils anbringbar sind.

Gemäß einer Weiterbildung des erfindungsgemäßen Verfahrens kann vorgesehen sein, dass drei Klebepunkte vorgesehen sind, deren gedachte Verbindungsgeraden ein gleichseitiges Dreieck bilden, wobei der Schwerpunkt dieses gleichseitigen Dreiecks mit dem Mittelpunkt der unteren Fläche zusammen fällt. Die Stabilität der Klebeverbindung des elektronischen Bauteils mit der Trägerplatte kann dadurch effizient und kostengünstig erhöht werden.

In einer besonders günstigen Ausführung des erfindungsgemäßen Verfahrens kann vorgesehen sein, dass die zumindest zwei Klebepunkte aus einem wärmehärtenden Klebematerial bestehen, wobei die für die Wärmehärtung erforderliche Temperatur unterhalb der Schmelztemperatur des Lötmaterials liegt. Dies gewährleistet die Herstellung einer positionsstabilen Verbindung des zumindest einen elektronischen Bauteils mit der Trägerplatte bereits vor dem Schmelzen des Lötmaterials, wodurch ein Verschieben, Verdrehen bzw. Verschwimmen des zumindest einen elektronischen Bauteils zuverlässig vorgebeugt werden kann. Alternativ dazu können auch beliebige andere Klebeverfahren und Klebematerialen verwendet werden. Wichtig ist, dass die Klebeverbindungen vor dem Einleiten des Schmelzvorganges des Lötmaterials hinreichend ausgehärtet sind.

In einer Weiterbildung des Verfahrens kann vorgesehen sein, dass die Klebepunkte in Positionen angeordnet sind, die in Schritt c) einer Wärmehärtung ausgesetzt werden und dabei im Wesentlichen gleichen thermischen Bedingungen ausgesetzt sind. Unter dem Ausdruck "im Wesentlichen gleichen thermische Bedingungen" wird im Rahmen dieser Anmeldung eine maximal zulässige Temperaturdifferenz von maximal 10°C, bevorzugt maximal 5°C zwischen den einzelnen Klebepunkten während des Wärmehärtungsvorgangs verstanden.

Gemäß einer weiteren vorteilhaften Ausführungsform des erfindungsgemäßen Verfahrens kann in Schritt a) das Volumen der Klebepunkte vorgebbar sein. Das Volumen der Klebepunkte kann in einfacher Weise durch eine gezielte Dosierung der pro Klebepunkt aufgebrachten Klebemenge beeinflusst werden. Das Verfahren kann somit an die Erfordernisse und Abmessungen einzelner elektronischer Bauteile in einfacher Weise angepasst werden.

In einer ersten Variante des erfindungsgemäßen Verfahrens kann es vorgesehen sein, dass ein an der (Printplattenoberfläche) Trägerplattenoberfläche aufgebrachter Lötstopplack einen Randbereich der zumindest einen Trägerplattenkontaktfläche überdeckt und in Schritt a) Klebepunkte in diesem Randbereich auf dem Lötstopplack angebracht werden. Die Haftung und die Höhe der Klebepunkte können somit gezielt beeinflusst werden.

In einer alternativen zweiten Variante des erfindungsgemäßen Verfahrens kann vorgesehen sein, dass ein an der Printplattenoberfläche/Trägerplattenoberfläche aufgebrachter Lötstopplack vor einem Randbereich der zumindest einen Trägerplattenkontaktfläche endet und in Schritt a) Klebepunkte in diesem Randbereich auf dem Lötstopplack angebracht sind. Die Haftung und die Höhe der Klebepunkte können somit gezielt beeinflusst werden.

Die Angaben zu den Klebepunkten beziehen sich, sofern nicht anders angegeben, immer auf ein einzelnes elektronisches Bauteil. Werden mehrere elektronische Bauteile gemäß erfindungsgemäßen Verfahren fixiert, so werden hierfür die Klebepunkte an dem jeweiligen elektronischen Bauteil in obig beschriebener Weise angebracht.

Um eine Hin- und Rückleitung einer elektrischen Verbindung des zumindest einen elektronischen Bauteils mit der Trägerplatte zu ermöglichen, ist in einer günstigen Variante des erfindungsgemäßen Verfahrens vorgesehen, dass das zumindest eine elektronische Bauteil zumindest zwei oder drei Bauteilkontaktflächen und zumindest zwei oder drei korrespondierende Trägerplattenkontaktflächen aufweist. Die zumindest zwei Bauteilkontaktflächen sind voneinander elektrisch isoliert (abgesehen von der durch die Kontaktflächen gespeisten für die Bauteilfunktion notwendigen elektrischen Verbindung) sowie die zumindest zwei dazu korrespondierenden Trägerplattenkontaktflächen voneinander elektrisch isoliert sind- ein Stromkreis kann daher über jeweils korrespondierende Kontaktflächen (der Trägerplatte und des zumindest einem elektronischen Bauteils) über das zumindest eine elektronische Bauteil schließen. Eine dritte Kontaktfläche (Bauteil- und Trägerkontaktfläche) kann beispielsweise vorgesehen sein, um einen Wärmeübergang von dem elektronischen Bauteil hin zu der Trägerplatte zu ermöglichen. Die Trägerplatte könnte hierfür mit einem Kühlkörper bestückt sein oder aber auch als Kühlkörper ausgebildet sein.

In einer besonders günstigen Ausgestaltung des erfindungsgemäßen Verfahrens kann vorgesehen sein, dass das zumindest eine elektronische Bauteil eine LED ist. Die Abstrahlrichtung und Position der LED kann somit besonders genau festgelegt werden.

Eine besonders platzsparende Anordnung des zumindest einen elektronischen Bauteils lässt sich erreichen, indem das zumindest eine elektronische Bauteil ein SMD- Bauteil, insbesondere ein SMD-Bauteil ohne abstehenden Anschlusspins bzw. Bauteilkontaktflächen ("flat no lead"-Bauteil) ist.

Vorteilhafterweise kann das Verhältnis von dem Gewicht des zumindest einen elektronischen Bauteils zur elektrisch wirksamen Kontaktfläche kleiner als 50 mg/mm², vorzugsweise kleiner als 10mg/mm² ist. Bei der elektrisch wirksamen Kontaktfläche handelt es sich um jene Fläche, die mit der das elektronische Bauteil die Trägerplatte elektrisch kontaktiert.

Die Erfindung samt weiteren Ausgestaltungen und Vorteilen ist im Folgenden an Hand einer beispielhaften, nicht einschränkenden Ausführungsform näher erläutert, die in den Figuren veranschaulicht ist. Hierbei zeigt
Fig. 1 eine Draufsicht eines auf einer Trägerplatte festgeklebten elektronischen Bauteils,
Fig. 2 einen Ausschnitt einer Schnittdarstellung einer ersten Variante einer Klebeverbindung des elektronischen Bauteils mit der Trägerplatte gemäß der Schnittlinie AA der Fig. 1,
Fig. 3 einen Ausschnitt einer Schnittdarstellung einer zweiten Variante einer Klebeverbindung des elektronischen Bauteils mit der Trägerplatte gemäß der Schnittlinie AA der Fig. 1,
Fig. 4 eine schematische Darstellung eines Temperaturverlaufs und
Fig. 5 eine beispielhafte Darstellung einer Wahrscheinlichkeitsverteilungsfunktion eines radialen Positionsfehlers eines mithilfe des erfindungsgemäßen Verfahrens befestigten elektronischen Bauteils.

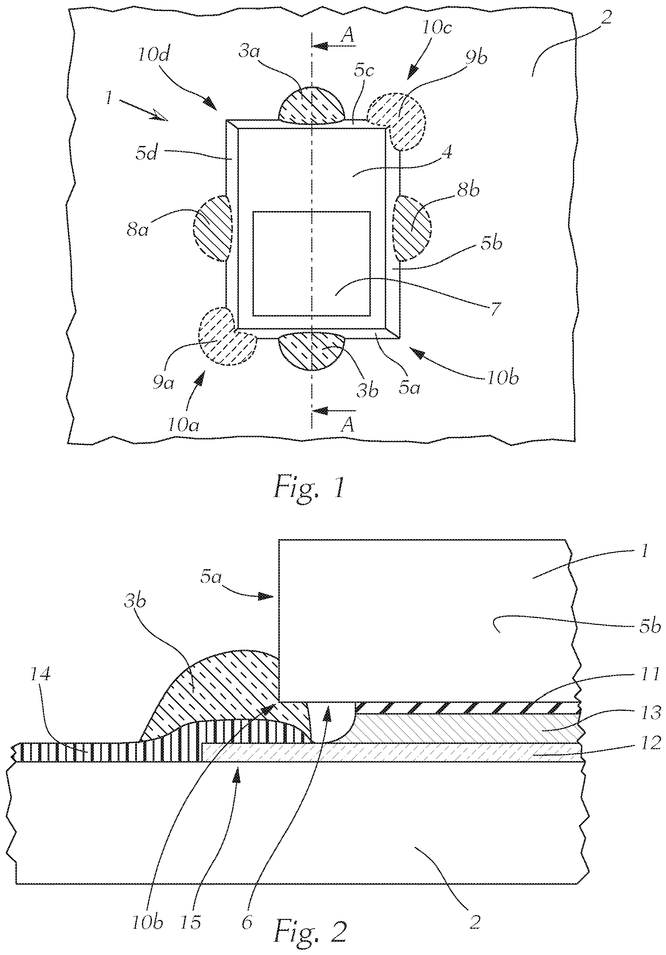

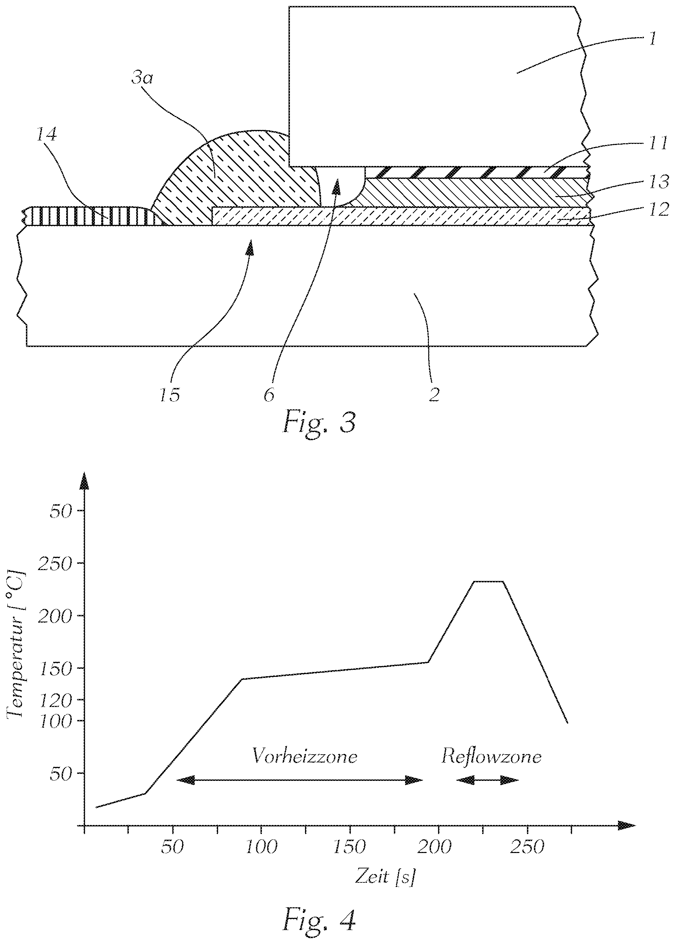

Fig. 1 zeigt ein elektronisches Bauteil 1, wobei das elektronische Bauteil ein optoelektronisches Bauteil ist, in einer Draufsicht, welches an einem Ausschnitt einer Trägerplatte 2 mithilfe zweier Klebepunkte 3a, 3b befestigt ist (die Klebepunkte 3a und 3b wurden zuvor auf die Trägerplatte 2 aufgebracht und die Trägerplatte 2 wurde im Anschluss mit dem elektronischen Bauteil 1 bestückt; die Klebepunkte 3a und 3b könnten theoretisch auch nach Bestückung mit dem elektronischen Bauteil 1 auf die Trägerplatte aufgebracht werden, allerdings besteht die Gefahr, dass das elektronische Bauteil 1 durch das Applizieren des Klebers und dadurch entstehende Kräfte in seiner Position verschoben wird). Das elektronische Bauteil 1 weist eine im Wesentlichen rechteckige Form auf und wird durch eine obere Fläche 4, vier Seitenflächen 5a, 5b, 5c und 5d sowie eine untere Fläche 6 (siehe Fig. 2 und 3), die sich der oberen Fläche 4 gegenüberliegend zwischen den vier Seitenflächen 5a bis 5d erstreckt, begrenzt. Das elektronische Bauteil 1 weist an der oberen Fläche 4 eine Kopplungsfläche 7 auf. Das elektronische Bauteil 1 kann beispielsweise ein Sensor oder eine LED sein, wobei die Kopplungsfläche 7 beispielhaft eine Sensorfläche zur Aufnahme externe Signale (Licht, Temperatur etc.) oder eine Lichtemissionsfläche beispielsweise einer LED sein kann. Die Klebepunkte 3a und 3b sind dergestalt angeordnet, dass eine gedachte Verbindungsgerade (welche im gezeigten Beispiel mit der Schnittlinie AA zusammenfällt) zwischen den Klebepunkten das elektronische Bauteil 1 in zwei gleichgroße Hälften teilt und die Verbindungsgerade somit einen gedachten Mittelpunkt der unteren Fläche 6 schneidet.

Darüber hinaus sind in Fig. 1 alternative Varianten von Klebepunktanordnungen angedeutet. So könnten zwei Klebepunkte 8a und 8b vorgesehen sein, die im Wesentlichen einer 90° Verdrehung der Klebepunkte 3a bzw. 3b entsprechen. Alternativ dazu könnten Klebepunkte 9a und 9b vorgesehen sein, die an Ecken 10a bzw. 10b des elektronischen Bauteils 1 angeordnet sind, wobei eine gedachte Verbindungsgerade durch die diese Ecken 10a bzw. 10b den gedachten Mittelpunkt der unteren Fläche 6 schneidet. In einer weiteren Variante könnte auch jede Ecke 10a, 10b, 10c, 10d einen Klebepunkt aufweisen. Darüber hinaus könnte auch vorgesehen sein, dass die Klebepunkte in Form eines gleichseitigen Dreiecks um das elektronische Bauteil 1 herum angeordnet sind, wobei vorzugsweise der Schwerpunkt diese gleichseitigen Dreiecks mit dem gedachten Mittelpunkt der unteren Fläche 6 zusammenfällt.

Wie bereits eingangs erwähnt wird unter dem Ausdruck "Ecke des elektronischen Bauteils 1" ein Bereich verstanden, an welchem sich der Verlauf einer zwischen einer Seitenfläche und der unteren Fläche 6 gebildeten Kante des elektronischen Bauteils dergestalt ändert, dass eine Ecke ausgebildet wird. Die Ecke 10a wird daher im Wesentlichen durch den gemeinsamen Schnittpunkt der Seitenflächen 5a und 5d mit der unteren Fläche 6 gebildet. Analog dazu wird die Ecke 10b im Wesentlichen durch den gemeinsamen Schnittpunkt der Seitenflächen 5a und 5b mit der unteren Fläche 6 gebildet (die Ecken 10c und 10d können analog über die Seitenflächen 5b und 5c, 5c und 5d bzw. die untere Fläche 6 definiert werden).

Fig. 2 zeigt einen Ausschnitt einer Schnittdarstellung einer ersten Variante einer Klebeverbindung des elektronischen Bauteils 1 mit der Trägerplatte 2 gemäß der Schnittlinie AA der Fig. 1. Das elektronische Bauteil 1 weist darin eine an der unteren Fläche 6 angeordnete Bauteilkontaktfläche 11 auf, welche über eine Schicht Lötmaterial 13 eine darunter befindliche, an der Oberfläche der Trägerplatte 2 angeordnete Trägerplattenkontaktfläche 12 kontaktiert. Unter dem Ausdruck "untere Fläche 6" wird jene Fläche des Bauteils 1 verstanden, welche der Trägerplatte 2 zugewandt ist. Die obere Fläche 4 des Bauteils 1 ist dementsprechend der Trägerplatte 2 abgewandt. Die Bauteilkontaktfläche 11 und die Trägerplattenkontaktfläche 12 müssen nicht durchgängig sein sondern können sich zur Herstellung mehrerer voneinander getrennter Kontakte aus mehreren einzelnen Kontaktflächen bestehen. Typischerweise können zwei oder drei Bauteilkontaktflächen sowie dazu korrespondierende Trägerplattenkontaktflächen vorgesehen sein. Die Oberfläche der Trägerplatte 2 weist des Weiteren abschnittsweise eine Beschichtung mit einem (in Fig. 1 nicht dargestellten) Lötstopplack 14 auf, welcher sich bis hin zu einem Randbereich 15 der Trägerplattenkontaktfläche 12 erstreckt und diesen überdeckt. Der Klebepunkt 3b (analog dazu der gegenüberliegende Klebepunkt 3a) befindet sich auf dem Lötstopplack 14 innerhalb dieses Randbereichs 15, wobei ein durch die Seitenfläche 5a und die untere Fläche 6 gebildeter Kantenbereich in den Klebepunkt 3b eingetaucht und somit mit diesem kontaktierend verbunden ist.

In Fig. 3 ist ein Ausschnitt einer Schnittdarstellung einer zweiten Variante einer Klebeverbindung des elektronischen Bauteils 1 mit der Trägerplatte 2 gemäß der Schnittlinie AA der Fig. 1 dargestellt, wobei analog zur Fig. 2, sofern nicht anders angegeben, gleiche Bezugszeichen die gleichen Merkmale wie in Fig. 1 beschreiben. Die in Fig. 3 gezeigte Variante der Erfindung unterscheidet sich von Fig. 2 indem der Lötstopplack 14 bereits vor dem Randbereich 15 der Trägerplattenkontaktfläche 12 endet und der Klebepunkt 3b (sowie analog dazu weitere Klebepunkte) direkt in diesem Randbereich im Wesentlichen auf der Trägerplattenkontaktfläche 12 angebracht ist.

Als Randbereich 15 wird im Rahmen dieser Anmeldung jener Bereich der Trägerplattenkontaktfläche 12 verstanden, der nicht von Lötmaterial 13 bedeckt ist und in unmittelbarer Nähe des elektronischen Bauteils 1 liegt, typischerweise in einer Entfernung von maximal 0,07mm, 0,1 mm, 0,2 mm oder 0,5mm.

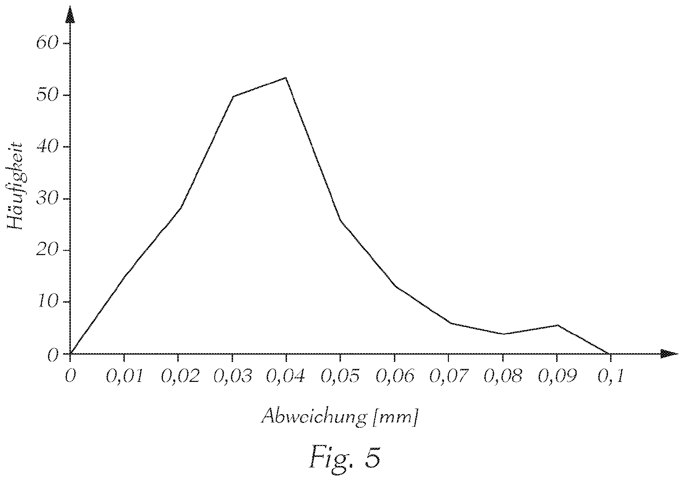

Nun verweisend auf Fig. 4 ist eine schematische Darstellung eines Temperaturverlaufs gezeigt, welchem das elektronische Bauteil 1 typischerweise vor, während und nach einem Reflow-Lötvorgang ausgesetzt ist. Das elektronische Bauteil 1 wird zuerst erwärmt und erreicht eine Vorheizzone (beispielhaft für eine Zeitdauer von 150 Sekunden bei Temperaturen von bis zu ca. 160 °C), in welcher beispielsweise wärmehärtende Klebepunkte aushärten können und das Lötmaterial 13 noch nicht schmilzt, um vorteilhafterweise sicherzustellen, dass der Kleber härtet bevor das Lötmaterial seine Halte/-Klebekraft verliert. Nach einer definierten Zeitdauer wird die Temperatur rasch erhöht (.z.B. innerhalb von ca. 50 Sekunden auf eine Temperatur von ca. 250 °C, welche für in etwa 50 Sekunden gehalten wird), um das Lötmaterial 13 rasch zu schmelzen und mit den beiden Kontaktflächen 11 und 12 dauerhaft zu verbinden. Nach Ablauf einer definierten Zeitdauer (z.B. ca. 100 Sekunden, die das rasche Erwärmen und das Halten der Temperatur von ca. 250 °C in Anspruch nimmt) kann im Anschluss die Temperatur wieder gesenkt werden. Das elektronische Bauteil 1 ist danach mit der Trägerplatte 2 dauerhaft elektrisch, mechanisch und/oder thermisch verbunden. Fig. 5 zeigt eine beispielhafte Darstellung einer Wahrscheinlichkeitsverteilungsfunktion eines radialen Positionsfehlers eines mithilfe des erfindungsgemäßen Verfahrens befestigten elektronischen Bauteils 1. Der arithmetische Mittelwert dieses radialen Positionsfehlers liegt bei herkömmlichen Lötverfahren in der Größenordnung von über 150 µm. Die in Fig. 5 dargestellte Häufigkeitsverteilung des radialen Positionsfehlers (Abweichung in mm) zeigt ein deutliches Maximum im Bereich zwischen 25 und 50 µm, wobei der maximale Positionsfehler 90 µm betrug.

Der Vollständigkeit halber sei noch darauf hingewiesen, dass die Trägerplatte 2 natürlich einen Vielzahl an elektronischen Bauteilen 1 aufweisen kann, die dank der Erfindung einerseits besonders nahe zueinander sowie auch positionsstabil angeordnet werden können.

## Patentansprüche

1. Verfahren zum positionsstabilen Verlöten zumindest einer Bauteilkontaktfläche (11) eines elektronischen Bauteils (1) mit zumindest einer korrespondierenden Trägerplattenkontaktfläche (12) einer Trägerplatte (2), wobei das zumindest eine elektronische Bauteil (1) eine untere und obere Fläche (6 und 4) sowie zumindest eine die untere mit der oberen Fläche (6 und 4) verbindende Seitenfläche (5a, 5b, 5c, 5d) aufweist, wobei die zumindest eine Bauteilkontaktfläche (11) an der unteren Fläche (6) ausgebildet ist und die zumindest eine Trägerplattenkontaktfläche (12) zumindest teilweise Lötmaterial (13), nämlich Lötpaste, aufweist, welches vor seiner Schmelzung verformbar ist, sodass die Position eines mit der Trägerplattenkontaktfläche (12) in elektrischen Kontakt stehenden Bauteils (1) verändert werden kann, ohne dass der elektrische Kontakt unterbrochen wird, wobei das elektronische Bauteil (1) ein optoelektronisches Bauteil ist, das an seiner oberen Fläche (4) eine Kopplungsfläche (7) aufweist, die beispielsweise eine Sensorfläche zur Aufnahme externer Signale oder eine Lichtemissionsfläche einer LED sein kann, wobei das Verfahren folgende Schritte aufweist:
a) Anbringen von zumindest zwei Klebepunkten (3a, 3b, 8a, 8b, 9a, 9b) an der Trägerplatte (2), wobei die Position jedes Klebepunktes (3a, 3b, 8a, 8b, 9a, 9b) vorgegeben wird, wobei die Trägerplatte (2) bereits vor Schritt b) das Lötmaterial (13) aufweist,
b) Bestücken der Trägerplatte (2) mit dem zumindest einen elektronischen Bauteil (1), wobei die Position der Klebepunkte (3a, 3b, 8a, 8b, 9a, 9b) in Schritt a) dergestalt vorgegeben wird, dass das zumindest eine elektronische Bauteil (1) die zumindest zwei Klebepunkte (3a, 3b, 8a, 8b, 9a, 9b) im Wesentlichen in einem durch die zumindest eine Seitenfläche (5a, 5b, 5c, 5d) und die untere Fläche 6 gebildeten Kantenbereich kontaktiert und die zumindest eine Bauteilkontaktfläche (11) mit der zumindest einen Trägerplattenkontaktfläche (12) zumindest teilweise überlappt,
c) Abwarten eines Aushärtevorgangs der Klebepunkte (3a, 3b, 8a, 8b, 9a, 9b) für eine vorgebbare Zeitdauer t, um ein Verschwimmen des elektronischen Bauteils (1) beim Lötvorgang zu verhindern,
d) Erhitzen des Lötmaterials (13) zum Herstellen einer elektrischen, mechanischen und/oder thermischen Verbindung zwischen der zumindest einen Bauteilkontaktfläche (11) und der zumindest einen Trägerplattenkontaktfläche (12).

2. Verfahren nach Anspruch 1, **dadurch gekennzeichnet, dass** die Klebepunkte (3a, 3b, 8a, 8b, 9a, 9b) dergestalt angeordnet sind, dass eine gedachte Verbindungsgerade zwischen den Klebepunkten (3a, 3b, 8a, 8b, 9a, 9b) eine Gerade durch den Mittelpunkt der unteren Fläche (6) des zumindest einen elektronischen Bauteils (1) bildet.

3. Verfahren nach Anspruch 1 oder 2, **dadurch gekennzeichnet, dass** die Klebepunkte (3a, 3b, 8a, 8b, 9a, 9b) dergestalt angeordnet sind, dass jeweils ein Klebepunkt (3a, 3b, 8a, 8b, 9a, 9b) an einer Ecke (10a, 10b, 10c, 10d) des zumindest einen elektronischen Bauteils (1) angeordnet ist.

4. Verfahren nach einem der Ansprüche 1 bis 3, **dadurch gekennzeichnet, dass** zu jeder Ecke (10a, 10b, 10c, 10d) des elektronischen Bauteils (1) ein korrespondierender Klebepunkt (3a, 3b, 8a, 8b, 9a, 9b) vorgesehen ist.

5. Verfahren nach Anspruch 1 oder 2, **dadurch gekennzeichnet, dass** drei Klebepunkte (3a, 3b, 8a, 8b, 9a, 9b) vorgesehen sind, deren gedachte Verbindungsgeraden ein gleichseitiges Dreieck bilden, wobei der Schwerpunkt dieses gleichseitigen Dreiecks mit dem Mittelpunkt der unteren Fläche (6) zusammen fällt.

6. Verfahren nach einem der Ansprüche 1 bis 5, **dadurch gekennzeichnet, dass** die zumindest zwei Klebepunkte (3a, 3b, 8a, 8b, 9a, 9b) aus einem wärmehärtenden Klebematerial bestehen, wobei die für die Wärmehärtung erforderliche Temperatur unterhalb der Schmelztemperatur des Lötmaterials (13) liegt.

7. Verfahren nach einem der Ansprüche 1 bis 6, **dadurch gekennzeichnet, dass** die Klebepunkte (3a, 3b, 8a, 8b, 9a, 9b) in Positionen angeordnet sind, die in Schritt c) einer Wärmehärtung ausgesetzt werden und dabei im Wesentlichen gleichen thermischen Bedingungen ausgesetzt sind.

8. Verfahren nach einem der Ansprüche 1 bis 7, **dadurch gekennzeichnet, dass** in Schritt a) das Volumen der Klebepunkte (3a, 3b, 8a, 8b, 9a, 9b) vorgebbar ist.

9. Verfahren nach einem der Ansprüche 1 bis 8, **dadurch gekennzeichnet, dass** ein an der Trägerplattenoberfläche aufgebrachter Lötstopplack (14) einen Randbereich (15) der zumindest einen Trägerplattenkontaktfläche (12) überdeckt und in Schritt a) Klebepunkte (3a, 3b, 8a, 8b, 9a, 9b) in diesem Randbereich (15) auf dem Lötstopplack (14) angebracht werden.

10. Verfahren nach einem der Ansprüche 1 bis 8, **dadurch gekennzeichnet, dass** ein an der Trägerplattenoberfläche aufgebrachter Lötstopplack (14) vor einem Randbereich (15) der zumindest einen Trägerplattenkontaktfläche (12) endet und in Schritt a) Klebepunkte (3a, 3b, 8a, 8b, 9a, 9b) in diesem Randbereich (15) auf dem Lötstopplack (14) angebracht sind.

11. Verfahren nach einem der Ansprüche 1 bis 10, **dadurch gekennzeichnet, dass** das zumindest eine elektronische Bauteil (1) zumindest zwei oder drei Bauteilkontaktflächen (11) und zumindest zwei oder drei korrespondierende Trägerplattenkontaktflächen (12) aufweist.

12. Verfahren nach einem der Ansprüche 1 bis 11, **dadurch gekennzeichnet, dass** das zumindest eine elektronische Bauteil (1) eine LED ist.

13. Verfahren nach einem der Ansprüche 1 bis 12, **dadurch gekennzeichnet, dass** das zumindest eine elektronische Bauteil (1) ein SMD- Bauteil ist insbesondere ein SMD-Bauteil ohne abstehenden Anschlusspins und/oder ohne abstehende Bauteilkontaktflächen (11) ist.

14. Verfahren nach einem der vorhergehenden Ansprüche, **dadurch gekennzeichnet, dass** das Verhältnis von dem Gewicht des zumindest einen elektronischen Bauteils (1) zur elektrisch wirksamen Kontaktfläche kleiner als 50 mg/mm², vorzugsweise kleiner als 10mg/mm² ist.

## Claims

1. Method for positionally stable soldering of at least one component contact surface (11) of an electronic component (1) to at least one corresponding carrier plate contact surface (12) of a carrier plate (2), the at least one electronic component (1) having a lower and upper surface (6 and 4) and at least one side surface (5a, 5b, 5c, 5d) connecting the lower surface (6) to the upper surface (4), the at least one component contact surface (11) being formed on the lower surface (6) and the at least one carrier plate contact surface (12) having at least partially soldering material (13), namely soldering paste, which is deformable prior to its melting, so that the position of a component (1) in electrical contact with the carrier plate contact surface (12) can be changed without the electrical contact being interrupted, wherein the electronic component (1) is an optoelectronic component which has a coupling surface (7) on its upper surface (4), which coupling surface (7) can be, for example, a sensor surface for receiving external signals or a light-emitting surface of an LED, the method comprising the following steps:
a) attaching at least two adhesive points (3a, 3b, 8a, 8b, 9a, 9b) to the carrier board (2), the position of each adhesive point (3a, 3b, 8a, 8b, 9a, 9b) being predetermined, the carrier board (2) already having the solder material (13) before step b),
b) equipping the carrier plate (2) with the at least one electronic component (1), the position of the adhesive points (3a, 3b, 8a, 8b, 9a, 9b) being predetermined in step a) in such a way that the at least one electronic component (1) substantially covers the at least two adhesive points (3a, 3b, 8a, 8b, 9a, 9b), 9a, 9b) substantially in an edge region formed by the at least one side surface (5a, 5b, 5c, 5d) and the bottom surface 6, and the at least one component contact surface (11) at least partially overlaps with the at least one carrier plate contact surface (12),
c) waiting for the adhesive dots (3a, 3b, 8a, 8b, 9a, 9b) to cure for a predeterminable period of time t in order to prevent the electronic component (1) from becoming blurred during the soldering process,
d) heating the solder material (13) to establish an electrical, mechanical and/or thermal connection between the at least one component contact surface (11) and the at least one carrier plate contact surface (12).

2. Method according to claim 1, **characterised in that** the adhesive points (3a, 3b, 8a, 8b, 9a, 9b) are arranged in such a way that an imaginary connecting straight line between the adhesive points (3a, 3b, 8a, 8b, 9a, 9b) forms a straight line through the centre point of the lower surface (6) of the at least one electronic component (1).

3. Method according to claim 1 or 2, **characterised in that** the adhesive points (3a, 3b, 8a, 8b, 9a, 9b) are arranged in such a way that in each case one adhesive point (3a, 3b, 8a, 8b, 9a, 9b) is arranged at a corner (10a, 10b, 10c, 10d) of the at least one electronic component (1).

4. A method according to any one of claims 1 to 3, **characterized in that** a corresponding bonding point (3a, 3b, 8a, 8b, 9a, 9b) is provided for each corner (10a, 10b, 10c, 10d) of the electronic component (1).

5. Method according to claim 1 or 2, **characterised in that** three adhesive points (3a, 3b, 8a, 8b, 9a, 9b) are provided whose imaginary connecting lines form an equilateral triangle, the centre of gravity of this equilateral triangle coinciding with the centre of the lower surface (6).

6. A method according to any one of claims 1 to 5, **characterized in that** the at least two adhesive dots (3a, 3b, 8a, 8b, 9a, 9b) are made of a thermosetting adhesive material, the temperature required for thermosetting being below the melting temperature of the solder material (13).

7. A method according to any one of claims 1 to 6, **characterised in that** the bonding points (3a, 3b, 8a, 8b, 9a, 9b) are located in positions which are subjected to heat curing in step c) and are subjected to substantially the same thermal conditions.

8. Method according to one of claims 1 to 7, **characterised in that** in step a) the volume of the adhesive dots (3a, 3b, 8a, 8b, 9a, 9b) can be predetermined.

9. Method according to one of claims 1 to 8, **characterized in that** a solder resist (14) applied to the solder resist (14) applied to the carrier plate surface covers an edge region (15) of at least one at least one carrier plate contact surface (12) and in step a) adhesive dots (3a, 3b, 8a, 8b, 9a, 9b) are applied to the solder resist (14) in this edge region (15).

10. Method according to one of claims 1 to 8, **characterized in that** a solder resist (14) applied to the carrier plate surface ends in front of an edge region (15) of the at least one carrier plate contact surface (12) and in step a) adhesive dots (3a, 3b, 8a, 8b, 9a, 9b) are applied to the solder resist (14) in this edge region (15).

11. A method according to any one of claims 1 to 10, **characterised in that** the at least one electronic component (1) has at least two or three component contact areas (11) and at least two or three corresponding carrier plate contact areas (12).

12. Method according to one of claims 1 to 11, **characterised in that** the at least one electronic component (1) is an LED.

13. Method according to one of the claims 1 to 12, **characterised in that** the at least one electronic component (1) is an SMD component, in particular an SMD component without protruding connection pins and/or without protruding component contact surfaces (11).

14. Method according to one of the preceding claims, **characterized in that** the ratio of the weight of the at least one electronic component (1) to the electrically effective contact area is less than 50 mg/mm2, preferably less than 10 mg/mm2.

## Revendications

1. Procédé de brasage à position stable d'au moins une surface de contact de composant (11) d'un composant électronique (1) avec au moins une surface de contact de plaque de support correspondante (12) d'une plaque de support (2), ledit au moins un composant électronique (1) ayant des surfaces inférieure et supérieure (6 et 4) et au moins une surface latérale (5a, 5b, 5c, 5d) reliant les surfaces inférieure et supérieure (6 et 4), ladite au moins une surface de contact de composant (11) étant formée sur la surface inférieure (6) et ladite au moins une surface de contact de plaque de support (12) comprenant au moins partiellement un matériau de brasage (13), à savoir de la pâte à souder, qui est déformable avant sa fusion, de sorte que la position d'un composant (1) en contact électrique avec la surface de contact de la plaque de support (12) peut être modifiée sans que le contact électrique soit interrompu, le composant électronique (1) étant un composant optoélectronique qui présente sur sa surface supérieure (4) une surface de couplage (7) qui est par exemple une surface de capteur pour recevoir des signaux externes ou une surface d'une plaque de support, Peut-être une surface d'émission de lumière d'une LED, le procédé comprenant les étapes suivantes:
a) application d'au moins deux points de collage (3a, 3b, 8a, 8b, 9a, 9b) sur la plaque de support (2), la position de chaque point de collage (3a, 3b, 8a, 8b, 9a, 9b) étant prédéterminée, la plaque de support (2) comportant déjà le matériau de brasage (13) avant l'étape b),
b) équipement de la plaque de support (2) avec l'au moins un composant électronique (1), la position des points de collage (3a, 3b, 8a, 8b, 9a, 9b) étant prédéfinie à l'étape a) de telle sorte que l'au moins un composant électronique (1) traverse les au moins deux points de collage (3a, 3b, 8a, 8b, 9a, 9b) entre en contact essentiellement dans une zone de bord formée par ladite au moins une surface latérale (5a, 5b, 5c, 5d) et ladite surface inférieure 6, et ladite au moins une surface de contact de composant (11) chevauche au moins partiellement ladite au moins une surface de contact de plaque de support (12),
c) Attendre un processus de durcissement des points de collage (3a, 3b, 8a, 8b, 9a, 9b) pendant une durée t pouvant être prédéfinie, afin d'éviter un flou du composant électronique (1) lors du processus de brasage,
d) chauffer le matériau de brasage (13) pour établir une connexion électrique, mécanique et/ou thermique entre ladite au moins une surface de contact de composant (11) et ladite au moins une surface de contact de plaque de support (12)

2. Procédé selon la revendication 1, **caractérisé en ce que** les points de collage (3a, 3b, 8a, 8b, 9a, 9b) sont disposés de telle sorte qu'une droite imaginaire de liaison entre les points de collage (3a, 3b, 8a, 8b, 9a, 9b) forme une droite passant par le centre de la surface inférieure (6) du au moins un composant électronique (1).

3. Procédé selon la revendication 1 ou 2, **caractérisé en ce que** les points de colle (3a, 3b, 8a, 8b, 9a, 9b) sont disposés de telle sorte qu'un point de collage (3a, 3b, 8a, 8b, 9a, 9b) est disposé sur un coin (10a, 10b, 10c, 10d) du au moins un composant électronique (1).

4. Procédé selon l'une des revendications 1 à 3, **caractérisé en ce qu'**il est prévu un point de collage (3a, 3b, 8a, 8b, 9a, 9b) correspondant à chaque coin (10a, 10b, 10c, 10d) du composant électronique (1).

5. Procédé selon la revendication 1 ou 2, **caractérisé en ce que** trois points de collage (3a, 3b, 8a, 8b, 9a, 9b) sont prévus, dont les droites de liaison imaginaires forment un triangle équilatéral, le centre de gravité de ce triangle équilatéral coïncidant avec le centre de la surface inférieure (6).

6. Procédé selon l'une des revendications 1 à 5, **caractérisé en ce que** lesdits au moins deux points de collage (3a, 3b, 8a, 8b, 9a, 9b) sont constitués d'un matériau adhésif thermodurcissable, la température nécessaire au thermodurcissement étant inférieure à la température de fusion du matériau de brasage (13).

7. Procédé selon l'une quelconque des revendications 1 à 6, **caractérisé en ce que** les points de collage (3a, 3b, 8a, 8b, 9a, 9b) sont disposés dans des positions qui sont soumises à un durcissement thermique à l'étape c) et sont ainsi soumises à des conditions thermiques sensiblement identiques.

8. Procédé selon l'une quelconque des revendications 1 à 7, **caractérisé en ce que**, dans l'étape a) le volume des points de colle (3a, 3b, 8a, 8b, 9a, 9b) peut être prédéfini.

9. Procédé selon l'une quelconque des revendications 1 à 8, **caractérisé en ce qu'**un vernis épargne de soudure (14) appliqué sur la surface de la plaque support recouvre une zone marginale (15) de ladite au moins une surface de contact (12) de la plaque support et, à l'étape a), des points de colle (3a, 3b, 8a, 8b, 9a, 9b) sont appliquées sur le vernis épargne (14) dans cette zone marginale (15).

10. Procédé selon l'une quelconque des revendications 1 à 8, **caractérisé en ce qu'**un vernis épargne de soudure (14) appliqué sur la surface de la plaque de support se termine avant une zone marginale (15) de ladite au moins une surface de contact (12) de la plaque de support et, à l'étape a), des points de colle (3a, 3b, 8a, 8b, 9a, 9b) sont appliquées sur le vernis épargne (14) dans cette zone marginale (15).

11. Procédé selon l'une des revendications 1 à 10, **caractérisé en ce que** ledit au moins un composant électronique (1) comporte au moins deux ou trois plages de contact de composant (11) et au moins deux ou trois plages de contact de plaque support (12) correspondantes.

12. Procédé selon l'une des revendications 1 à 11, **caractérisé en ce que** ledit au moins un composant électronique (1) est une LED.

13. procédé selon l'une des revendications 1 à 12, **caractérisé en ce que** le au moins un composant électronique (1) est un composant CMS, en particulier un composant CMS sans broches de connexion saillantes et/ou sans surfaces de contact de composant saillantes (11).

14. Procédé selon l'une des revendications précédentes, **caractérisé en ce que** le rapport entre le poids de l'au moins un composant électronique (1) et la surface de contact est inférieur à 50 mg/mm2 de préférence inférieur à 10mg/ mm2.
